# EUROPEAN PATENT SPECIFICATION

(11) **EP 3 396 712 B1**
(45) Date of publication and mention of the grant of the patent: **03.08.2022**
(21) Application number: 17191629.9
(22) Date of filing: 18.09.2017
(51) Int. Cl.: H01L 25/075, H01L 33/62, H01L 33/48, H01L 33/50

(54) **COLOR TEMPERATURE ADJUSTABLE LIGHT SOURCE DEVICE**
BELEUCHTUNGSQUELLENVORRICHTUNG MIT EINSTELLBARER FARBTEMPERATUR
DISPOSITIF DE SOURCE DE LUMIÈRE À TEMPÉRATURE DE COULEUR RÉGLABLE

(30) Priority: 24.04.2017 CN 201710271395; 24.04.2017 CN 201720436352 U
(43) Date of publication of application: 31.10.2018
(73) Proprietor: Ningbo Sunpu Led Co., Ltd., Hi-Tech Park Ningbo Zhejiang 315040 (CN)
(72) Inventor: DU, Yuanbao, Ningbo, Zhejiang 315040 (CN); ZHANG, Yaohua, Ningbo, Zhejiang 315040 (CN); CAI, Xiaoning, Ningbo, Zhejiang 315040 (CN); LIN, Sheng, Ningbo, Zhejiang 315040 (CN); ZHANG, Riguang, Ningbo, Zhejiang 315040 (CN)
(74) Representative: Boult Wade Tennant LLP

(56) References cited:
- WO-A2-2006/077488
- DE-A1-102005 059 362
- DE-A1-102008 013 049
- US-A1- 2003 067 775
- US-A1- 2007 223 219
- US-A1- 2012 099 303

## Description

### TECHNICAL FIELD

The present disclosure relates to the technical field of light source devices, and in particular to a color temperature adjustable light source device.

### BACKGROUND

Because of the increasing demand among people for light quality, the development of intelligent lighting becomes more and more prosperous. Intelligent lighting refers to a technology where the brightness, color, color temperature or the like of light emitted by a light source is adjustable, which can meet lighting requirements in different scenarios. The adjustable color temperature is a key technology in intelligent lighting.

An LED light source refers to a light source device using a light emitting diode (LED) as an illuminant. The LED has advantages such as having a long service life, a high luminous efficiency, low radiation, and low power consumption, as well as being safe, environmentally friendly and non-toxic. Hence, it is widely used for lighting.

For an existing LED light source realizing an adjustable color temperature, one may refer to Chinese Patent Publication No. CN106058017, which is published on October 26, 2016. An LED assembly includes a substrate, a first chip and a second chip fixed on a surface of the substrate, and a first fluorescent component and a second fluorescent component. The first chip is located in a first area within an area surrounded by a dam, and the second chip is arranged in a second area within the area surrounded by the dam. The first fluorescent component having a first color temperature is arranged on the first chip, with a brightness of the first fluorescent component being adjusted by the first chip. The second fluorescent component having a second color temperature is arranged on the first chip and the second chip, with a brightness of the second fluorescent component being adjusted by the first chip and the second chip. The brightness of the first fluorescent component and the brightness of the second fluorescent component are adjusted by continuously adjusting electrical parameters of the first chip and the second chip, thereby producing different color temperatures, thus a color temperature which is continuously adjustable between a high color temperature and a low color temperature can be implemented.

However, the above-described existing LED light source achieving an adjustable color temperature can only enable the color temperature to be continuously adjustable between the high color temperature and the low color temperature. Therefore, this color temperature adjustable light source cannot meet the increasing demand among people for light quality.

DE 102008013049A1 discloses an arrangement of LEDs for a lamp, which is provided to achieve a light spectrum similar to daylight. In an arrangement, a first group of colored LEDs is arranged in a row, and a group of warm white LEDs and cold white LEDs are arranged parallel to the first group of colored LEDs. In another arrangement, the first group of LEDs is arranged as a group of three in the form of an equilateral triangle. This first group is surrounded by the second group of LEDs that have four LEDs arranged in a square where two warm white LEDs and cold white LEDs are arranged diagonally opposite one another.

DE 102005059362A1 discloses an adjustable color daylight source that has at least one light emitting diode emitting white light of defined color temperature combined with light emitting diodes emitting light of least two different colors, where the light emitting diodes emitting light of least two different colors are surrounded by the light emitting diode emitting white lights. Color temperature adjustable light source devices are also disclosed in documents US 2007/223219 A1, US 2012/099303 A1, WO 2006/077488 A2 and US 2003/067775 A1.

### SUMMARY

In view of this, it is an object of the present invention to provide a color temperature adjustable light source device, by which a color temperature which is continuously adjustable along a blackbody curve can be achieved, thereby providing more comfort for human eyes.

To achieve the above objects, following technical solutions are provided in the present disclosure.

A color temperature adjustable light source device according to the invention is provided in claim 1.

Further preferred embodiments of the invention are defined in the dependent claims.

As can be seen from the above-described technical solution, the color temperature adjustable light source device according to the present invention includes a substrate, multiple light-emitting units, a control unit and the remaining features defined in claim 1. The multiple light-emitting units are arranged in a preset area on a surface of the substrate. The multiple light-emitting units include more than one first light-emitting units configured to generate light having a reference spectrum being a full spectrum white light, or yellow light, and monochromatic light-emitting units configured to generate light having spectrums of three primary colors respectively. The control circuit controls the first light-emitting units and the monochromatic light-emitting units to emit light, to control the generated spectrums of three primary colors to compensate the reference spectrum to form mixed light. By modulating the reference spectrum using the spectrums of three primary colors, different color temperatures can be outputted, such that a continuously adjustable color temperature of the light source can be achieved, and the color temperature of the light source is continuously adjustable along a blackbody curve.

### BRIEF DESCRIPTION OF THE DRAWINGS

The drawings to be used in the description of embodiments of the disclosure or the conventional technology are described briefly as follows, so that technical solutions according to the embodiments of the present disclosure or according to the conventional technology become clearer. It is apparent that the drawings in the following description only illustrate some embodiments of the present disclosure.
Figure 1 is a schematic diagram of a color temperature adjustable light source device according to an embodiment of the present disclosure, which does not form part of the claimed invention;
Figure 2 is a schematic diagram illustrating a circuit of the color temperature adjustable light source device shown in Figure 1;
Figure 3 is a schematic diagram of a color temperature adjustable light source device according to another embodiment of the present disclosure, which does not form part of the claimed invention; and
Figure 4 is a schematic diagram illustrating a circuit of the color temperature adjustable light source device shown in Figure 3.

### DETAILED DESCRIPTION OF THE EMBODIMENTS

Since the demand among people for light quality increases, the existing color temperature adjustable light source device cannot meet the demand among people. In view of this, a color temperature adjustable light source device is provided according to the present disclosure, wherein the invention is as defined in the appended claims. A color temperature which is continuously adjustable along a blackbody curve can be achieved with the color temperature adjustable light source device, thereby providing lighting which is more comfort for human eyes.

A color temperature adjustable light source device is provided according to the present disclosure, which includes a substrate, multiple light-emitting units and a control circuit. A color temperature adjustable light source device according to the invention is provided in the appended claims.

The multiple light-emitting units are arranged in a preset area on a surface of the substrate. The multiple light-emitting units include one or more first light-emitting units configured to generate light having a broad reference spectrum and monochromatic light-emitting units configured to generate light having spectrums of three primary colors respectively. The first light-emitting units according to the claimed invention are more than one and they generate full spectrum white light, or yellow light.

The control circuit is integrated in the substrate, and is configured to control the one or more first light-emitting units and the monochromatic light-emitting units to emit light, to control the generated spectrums of three primary colors to compensate the broad reference spectrum, to form mixed light.

In the color temperature adjustable light source device, the multiple light-emitting units are arranged in the preset area on the surface of the substrate. The multiple light-emitting units include one or more first light-emitting units configured to generate light having the broad reference spectrum and monochromatic light-emitting units configured to generate light having spectrums of three primary colors respectively.

The control circuit is integrated in the substrate. The control circuit controls the one or more first light-emitting units and the monochromatic light-emitting units to emit light.

In the light source device, the one or more first light-emitting units generates light having the broad reference spectrum, and the monochromatic light-emitting units generate light having spectrums of three primary colors respectively. The reference broad spectrum is modulated using the spectrums of three primary colors generated by the monochromatic light-emitting units, thereby generating light having a mixed spectrum, such that different color temperatures can be outputted. With the color temperature adjustable light source device according to the present disclosure, a color temperature of the light source which is continuously adjustable along the blackbody curve can be achieved.

The foregoing is the core idea of the present disclosure. In order that the objectives, features and advantages of the present disclosure can be clearer, the embodiments of the present disclosure are described in detail as follows in conjunction with the drawings.

Specific details are described in the following description so that the present disclosure can be understood completely. Therefore, the present disclosure is not limited to the specific embodiments described below and the invention is as defined in the appended claims.

In addition, the present disclosure is described in detail in conjunction with the schematic diagrams. When describing the embodiments of the present disclosure in detail, sectional views showing the structure of the device are not partially enlarged to a certain scale for ease of illustration. Moreover, the schematic diagrams are only examples, which should not be understood as limiting the scope of the disclosure. Furthermore, in an actual manufacture process, three-dimensioned measurements, i.e. the length, the width and the depth should be considered.

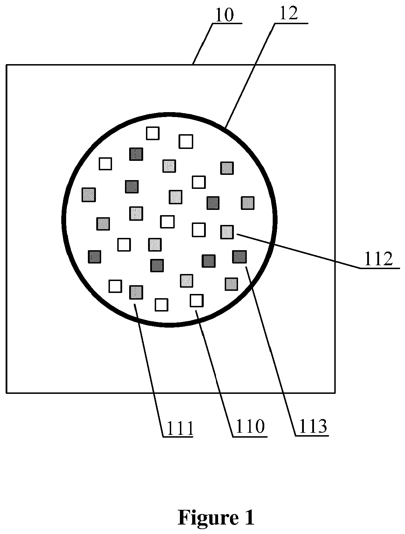

Reference is made to Figure 1. In an embodiment of the color temperature adjustable light source device according to the present disclosure, which does not form part of the claimed invention, the color temperature adjustable light source device includes a substrate 10, multiple light-emitting units 11 and a control circuit, as can be seen from Figure 1.

The light-emitting units 11 are arranged in a preset area on a surface of the substrate 10 to form a light-emitting surface. Specifically, a dam 12 is arranged on the surface of the substrate 10, and the preset area is surrounded by the dam 12.

The multiple light-emitting units 11 include first light-emitting units 110 and monochromatic light-emitting units.

The first light-emitting units 110 are configured to generate light that may have a broad reference spectrum which covers a broad spectral range. The first light-emitting units 110 generate full spectrum white light, or yellow light which has a narrower spectrum and is easier to modulate.

Specifically, the monochromatic light-emitting units include: a red light-emitting unit 111 configured to generate light having a spectrum in the red spectral band; a green light-emitting unit 112 configured to generate light having a spectrum in the green spectral band; and a blue light-emitting unit 113 configured to generate light having a spectrum in the blue spectral band.

The reference spectrum is modulated using the spectrums of three primary colors generated by the monochromatic light-emitting units, to form a spectral power distribution of mixed light, thereby outputting mixed light having different color temperatures, thus a continuously adjustable color temperature of the light source can be achieved, and the color temperature of the light source is continuously adjustable along the blackbody curve.

Optionally, the light-emitting unit 11 may be an LED chip integrated on the substrate 10, and light is generated by the LED chip.

Alternatively, the light-emitting unit 11 may include an LED chip integrated on the substrate 10 and a fluorescent material covering the LED chip. In this configuration, the LED chip generates light in the ultraviolet-to-blue spectral range, which excites the fluorescent material to emit light.

The control circuit is integrated in the substrate 10, and is configured to respectively control the first light-emitting units and the monochromatic light-emitting units to emit light, to control the generated spectrums of three primary colors to compensate the reference spectrum to form mixed light having different color temperatures

The following arrangement shown in Figure 1 is not according to the invention and is present for illustrative purposes only. In the arrangement of Figure 1, the number of the first light-emitting units 110 is greater than one, and the first light-emitting units 110 and the monochromatic light-emitting units are dispersedly distributed in the preset area, as shown in Figure 1. With this configuration, the light generated by the first light-emitting units and the light generated by the monochromatic light-emitting units can be mixed uniformly.

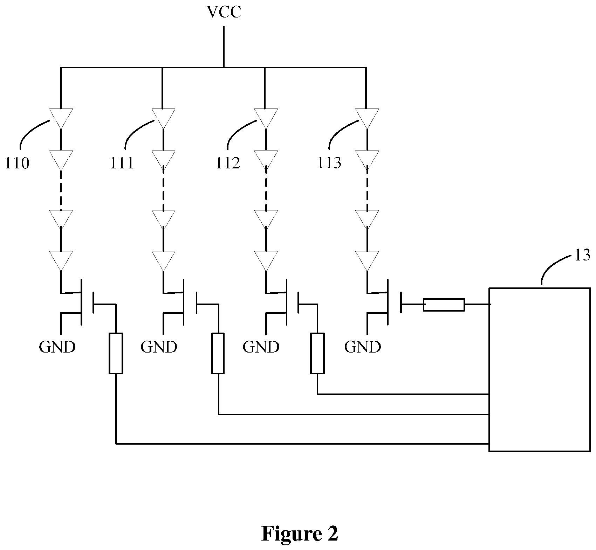

Reference is made to Figure 2, which is a schematic diagram illustrating a circuit of the first light-emitting units and the monochromatic light-emitting units according to this embodiment. As can be seen from Figure 2, the light source device further includes a micro controller unit 13 connected with the control circuit and configured to output a pulse signal to the control circuit. The micro controller unit 13 outputs the pulse signal to the control circuit to enable the control circuit to output pulse voltages to the first light-emitting units and the monochromatic light-emitting units. Lighting of the light-emitting units can be controlled by adjusting a duty cycle of the pulse signal, thereby implementing modulation of the broad reference spectrum using the spectrums of three primary colors.

In an embodiment of the color temperature adjustable light source device according to the present invention, the first light-emitting units are arranged at a center of the preset area, and the monochromatic light-emitting units are dispersedly distributed in the preset area. The number of the first light-emitting units is greater than one.

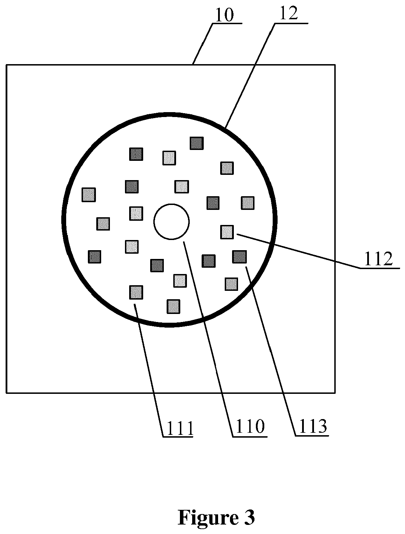

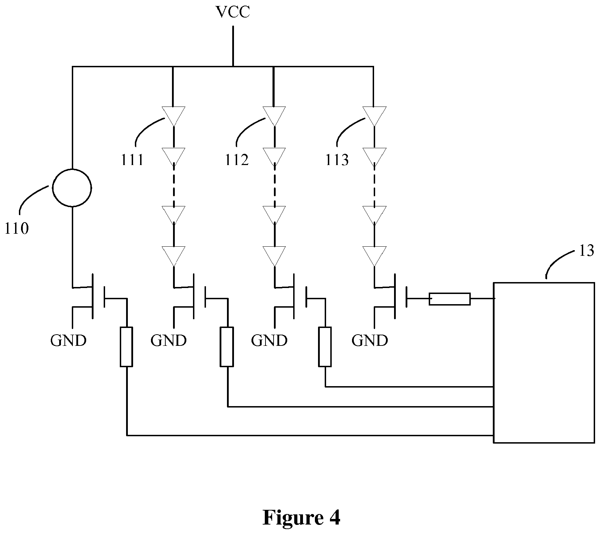

Reference is made to Figure 3. In the color temperature adjustable light source device as shown in Figure 3, the number of the first light-emitting units 110 is one, the first light-emitting unit 110 is arranged at the center of the preset area, and the monochromatic light-emitting units are dispersedly distributed in the preset area. The first light-emitting unit 110 is located at the center of the light-emitting surface and generates light having the broad reference spectrum. The monochromatic light-emitting units around the first light-emitting unit 110 generate light having spectrums of three primary colors to modulate the broad reference spectrum, thereby generating uniformly mixed light. The arrangement shown in Figure 3 is not according to the invention and is present for illustration purposes only. Reference is made to Figure 4, which is a schematic diagram illustrating a circuit of the first light-emitting unit and the monochromatic light-emitting units according to this embodiment. The micro controller unit 13 connected with the control circuit outputs a pulse signal to the control circuit to enable the control circuit to output pulse voltages to the first light-emitting unit and the monochromatic light-emitting units, such that lighting of the lighting units can be controlled by adjusting the duty cycle of the pulse signal, thereby implementing modulation of the broad reference spectrum using the spectrums of three primary colors.

In the color temperature adjustable light source device according to an embodiment of the invention, the number of the first light-emitting units is greater than one, and multiple first light-emitting units are distributed in a central area of the preset area on the surface of the substrate and generate full spectrum white light or yellow light.

With the color temperature adjustable light source device according to the embodiment, full spectrum white light or yellow light is generated, and the full spectrum white light or yellow light is modulated using spectrums of three primary colors, to form a spectral power distribution of mixed light, thereby outputting different color temperatures, thus a color temperature of the light source which is continuously adjustable along the blackbody curve can be achieved. Further, with the color temperature adjustable light source device, different color temperatures under a same color rendering index can be achieved.

The color temperature adjustable light source device according to the present disclosure is described in detail above. The principles and implementations are clarified using specific embodiments herein. The above description of the embodiments is only intended to help understanding the method of the present disclosure and the key concept thereof. The invention is as defined in the appended claims.

## Claims

1. A color temperature adjustable light source device, comprising:
a substrate (10);
a plurality of light-emitting units (11) arranged in a preset area on a surface of the substrate (10), wherein the plurality of light-emitting units (11) comprise first light-emitting units (110) configured to generate full spectrum white light or yellow light and monochromatic light-emitting units configured to generate light having spectrums of three primary colors respectively; and
a control circuit integrated in the substrate and configured to control the first light-emitting units (110) and the monochromatic light-emitting units to emit light, to control the generated spectrums of three primary colors to compensate the white light or yellow light to form mixed light,
wherein the number of the first light-emitting units (110) is greater than one;
wherein the first light-emitting units (110) are arranged at a center of the preset area, and the monochromatic light-emitting units are dispersedly distributed in the preset area.

2. The color temperature adjustable light source device according to claim 1, wherein a dam (12) is arranged on the surface of the substrate (10), and the preset area is surrounded by the dam (12).

3. The color temperature adjustable light source device according to claim 1, wherein the monochromatic light-emitting units comprise:
a red light-emitting unit (111) for generating light having a spectrum in a red spectral range;
a green light-emitting unit (112) for generating light having a spectrum in a green spectral range; and
a blue light-emitting unit (113) for generating light having a spectrum in a blue spectral range.

4. The color temperature adjustable light source device according to claim 1, wherein the light-emitting unit is a light emitting diode, LED, chip integrated on the substrate (10); or
the light-emitting unit comprises a light emitting diode, LED, chip integrated on the substrate (10) and a fluorescent material covering the LED chip.

5. The color temperature adjustable light source device according to claim 1, further comprising a micro controller unit (13) connected with the control circuit and configured to output a pulse signal to the control circuit.

## Patentansprüche

1. Lichtquellenvorrichtung mit einstellbarer Farbtemperatur, umfassend:
ein Substrat (10);
eine Mehrzahl von lichtemittierenden Einheiten (11), die auf einer vorgegebenen Fläche auf einer Oberfläche des Substrats (10) angeordnet sind, wobei die Mehrzahl von lichtemittierenden Einheiten (11) erste lichtemittierende Einheiten (110), die konfiguriert sind, um weißes Licht mit vollem Spektrum oder gelbes Licht zu erzeugen, und monochromatische lichtemittierende Einheiten umfasst, die konfiguriert sind, um Licht mit Spektren jeweils in drei Grundfarben zu erzeugen; und
eine in das Substrat integrierte Steuerschaltung, die konfiguriert ist, um die Lichterzeugung durch die ersten lichtemittierenden Einheiten (110) und die monochromatischen lichtemittierenden Einheiten zu steuern, um die erzeugten Spektren in den drei Grundfarben zu steuern, um das weiße Licht oder das gelbe Licht zu kompensieren, um Mischlicht zu bilden,
wobei die Anzahl der ersten lichtemittierenden Einheiten (110) größer als eins ist;
wobei die ersten lichtemittierenden Einheiten (110) in der Mitte der vorgegebenen Fläche angeordnet sind und die monochromatischen lichtemittierenden Einheiten in der vorgegebenen Fläche verstreut angeordnet sind.

2. Lichtquellenvorrichtung mit einstellbarer Farbtemperatur nach Anspruch 1, wobei ein Damm (12) auf der Oberfläche des Substrats (10) angeordnet ist und die vorgegebene Fläche von dem Damm (12) umgeben ist.

3. Lichtquellenvorrichtung mit einstellbarer Farbtemperatur nach Anspruch 1, bei der die monochromatischen lichtemittierenden Einheiten umfassen:
eine rotes Licht emittierende Einheit (111) zur Erzeugung von Licht mit einem Spektrum in einem roten Spektralbereich;
eine grünes Licht emittierende Einheit (112) zum Erzeugen von Licht mit einem Spektrum in einem grünen Spektralbereich; und
eine blaues Licht emittierende Einheit (113) zur Erzeugung von Licht mit einem Spektrum in einem blauen Spektralbereich.

4. Lichtquellenvorrichtung mit einstellbarer Farbtemperatur nach Anspruch 1, bei der die lichtemittierende Einheit ein auf dem Substrat (10) integrierter Chip einer lichtemittierenden Diode, LED, ist; oder
die lichtemittierende Einheit einen auf dem Substrat (10) integrierten LED-Chip und ein fluoreszierendes Material umfasst, das den LED-Chip bedeckt.

5. Lichtquellenvorrichtung mit einstellbarer Farbtemperatur nach Anspruch 1, die ferner eine Mikrosteuereinheit (13) umfasst, die mit der Steuerschaltung verbunden und konfiguriert ist, um ein Impulssignal an die Steuerschaltung auszugeben.

## Revendications

1. Dispositif de source de lumière à température de couleur réglable, comprenant :
un substrat (10) ;
une pluralité d'unités électroluminescentes (11) agencées dans une zone prédéfinie sur une surface du substrat (10), dans lequel la pluralité d'unités électroluminescentes (11) comprend des premières unités électroluminescentes (110) configurées pour générer une lumière blanche ou une lumière jaune à spectre complet et des unités électroluminescentes monochromatiques configurées pour générer une lumière présentant des spectres des trois couleurs primaires, respectivement ; et
un circuit de commande intégré dans le substrat et configuré pour commander les premières unités électroluminescentes (110) et les unités électroluminescentes monochromatiques pour émettre de la lumière, pour commander les spectres générés des trois couleurs primaires afin de compenser la lumière blanche ou la lumière jaune pour former une lumière mixte,
dans lequel le nombre des premières unités électroluminescentes (110) est supérieur à un ;
dans lequel les premières unités électroluminescentes (110) sont agencées au centre de la zone prédéfinie, et les unités électroluminescentes monochromatiques sont distribuées de manière dispersée dans la zone prédéfinie.

2. Dispositif de source de lumière à température de couleur réglable selon la revendication 1, dans lequel un barrage (12) est agencé sur la surface du substrat (10), et la zone prédéfinie est entourée par le barrage (12).

3. Dispositif de source de lumière à température de couleur réglable selon la revendication 1, dans lequel les unités électroluminescente monochromatiques comprennent :
une unité électroluminescente rouge (111) pour générer de la lumière présentant un spectre dans une plage spectrale rouge ;
une unité électroluminescente verte (112) pour générer de la lumière présentant un spectre dans une plage spectrale verte ; et
une unité électroluminescente bleue (113) pour générer de la lumière présentant un spectre dans une plage spectrale bleue.

4. Dispositif de source de lumière à température de couleur réglable selon la revendication 1, dans lequel l'unité électroluminescente est une puce à diode électroluminescente, DEL, intégrée sur le substrat (10) ; ou
l'unité électroluminescente comprend une puce à diode électroluminescente, DEL, intégrée sur le substrat (10) et un matériau fluorescent recouvrant la puce à DEL.

5. Dispositif de source de lumière à température de couleur réglable selon la revendication 1, comprenant en outre une unité de microcontrôleur (13) connectée au circuit de commande et configurée pour délivrer en sortie un signal d'impulsion vers le circuit de commande.
